Europäisches Patentamt

European Patent Office

Office européen des brevets

(19)

(11) Publication number:

**0 325 408**
**A2**

(12) # EUROPEAN PATENT APPLICATION

(21) Application number: **89300405.1**

(22) Date of filing: **17.01.89**

(51) Int. Cl.⁴: **H 01 L 23/52**

(30) Priority: **18.01.88 JP 6830/88**

(43) Date of publication of application:
**26.07.89 Bulletin 89/30**

(84) Designated Contracting States: **DE FR GB**

(71) Applicant: **FUJITSU LIMITED**
**1015, Kamikodanaka Nakahara-ku**
**Kawasaki-shi Kanagawa 211 (JP)**

(72) Inventor: **Sakurai, Junji**
**5-9-33, Seta Setagaya-ku**
**Tokyo 158 (JP)**

(74) Representative: **Silverman, Warren et al**
**HASELTINE LAKE & CO. Hazlitt House 28 Southampton**
**Buildings Chancery Lane**
**London WC2A 1AT (GB)**

The title of the invention has been amended (Guidelines for Examination in the EPO, A-III, 7.3).

(54) **Semiconductor device having an interconnection layer.**

(57) A semiconductor device comprises: interconnection portions (13) consisting of a ceramic superconducting material and a portion (14) positioned between the interconnection portions (13) and having the same main composition as that of the interconnection portions (13), the interconnection portions (13) being electrically insulated by the portion 14).

EP 0 325 408 A2

## Description

## SEMICONDUCTOR DEVICE

The present invention relates to a semiconductor device, more particularly it relates to a semiconductor device wherein an interconnection layer or portion consists of high temperature superconducting material.

Various ceramic high temperature superconducting materials have been developed, and when such a high temperature superconducting material is to be used as an interconnection (wiring) of, for example, LSI circuits, a thin film of the high temperature superconducting material is formed on a wafer and the thin film is then patterned by using a resist as a mask. When conventional patterning technology is applied, however, it is difficult to etch the ceramic high temperature superconducting material.

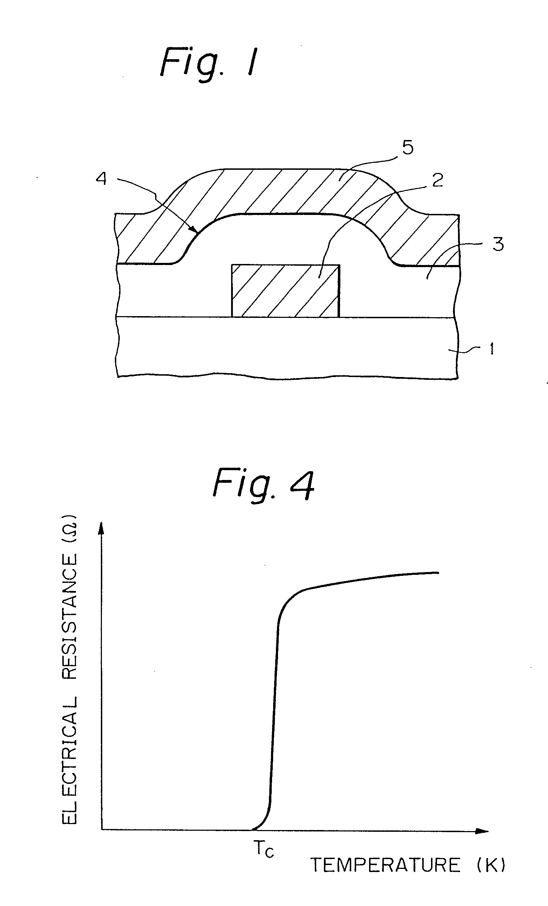

Figure 1 is a cross-sectional view explaining a conventional process for forming an interconnection.

As shown in Figure 1 an aluminium (Al) interconnection or wiring 2 is formed on a substrate 1 and an insulating layer 3 of phosphorus silicate glass (PSG) is deposited over the entire surface of the substrate 1. When the PSG layer 3 is deposited, a step 4 is formed at the corner portion of the interconnection 2, and thus a break in the interconnection frequently occurs at the step 4.

Further, planarization to reduce the step 4 often leads to a break in the PSG layer at step 4, which results in a short-circuit between the interconnection 2 and the other interconnection 5 at the step 4. Furthermore, due to the differences in the thermal expansion coefficients of the aluminium interconnection 2 and the PSG layer 3, stress occurs and thus the problem of a migration of aluminium arises.

These problems will increase as the device is made smaller and more compact.

An object of the present invention is to provide a semiconductor device wherein an interconnection or wiring can be easily formed, which interconnection may be conveniently formed as a three dimensional interconnection.

According to the present invention there is provided a semiconductor device comprising: interconnection portions consisting of a ceramic superconducting material and a portion positioned between said interconnection portions and having much of the composition of said interconnection portions but acting as an electrical insulator with respect to the interconnection portion at temperatures at which the latter are electrically conducting.

For a better understanding of the invention and to show how the same may be carried into effect, reference will now be made, by way of example only, to the accompanying drawings, wherein:

FIGURE 1 is a cross-sectional view explaining a conventional process for forming an interconnection (see above);

FIGURE 2 is a perspective view explaining the principle of the present invention;

FIGURES 3A and 3B are perspective views explaining further the present invention; and

FIGURE 4 is a graph illustrating a relationship between the electrical resistance and the temperature of the superconducting material.

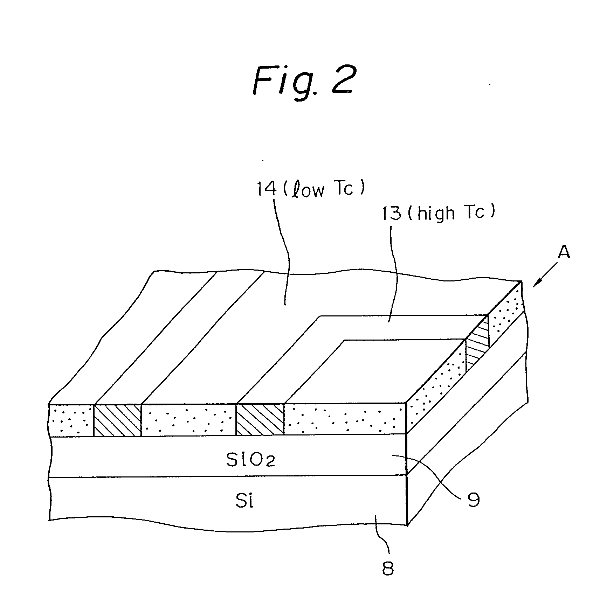

The principle of the present invention will first be explained with reference to Figure 2.

In Figure 2, an insulating layer 9 such as a silicon dioxide ($SiO_2$) layer is formed on a silicon substrate 8, and openings (not shown) are provided to connect the diffusion layer of the surface of the silicon substrate 8 to an interconnection portion (wiring) as required. A thin film A having much of the composition of a ceramic superconducting material is formed on the entire surface of the insulating layer 9, with a key composition generating the superconducting property being contained in only the interconnection portions 13 of the thin film A. The other portion 14 of the thin film A has much the same composition as that of the interconnection portions 13. The interconnection portions 13 are however electrically insulated by the portion 14.

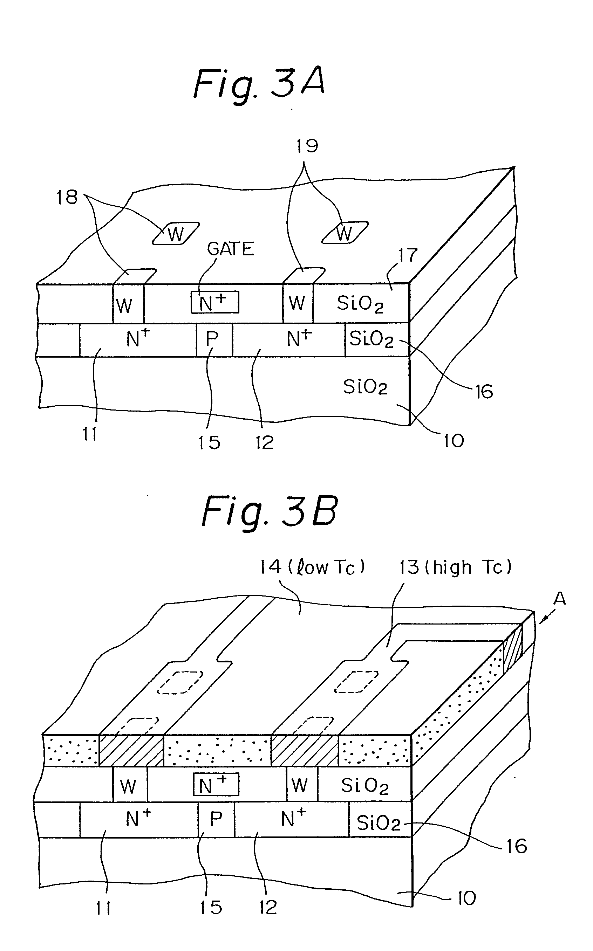

Figures 3A and 3B are perspective views explaining an embodiment of an interconnection portion of a semiconductor device according to the present invention.

As shown in Figure 3A, $N^+$ source and drain regions 11 and 12 are formed on a silicon dioxide ($SiO_2$) layer 10, and a P channel region 15 is provided between the $N^+$ source and drain regions 11 and 12. The $SiO_2$ layer 16 is an isolation region. An $SiO_2$ layer 17 is deposited on the source and drain regions 11 and 12, and is provided with source contacts 18 and drain contacts 19.

To electrically connect the source and drain contacts 18 and 19 to the interconnection or wiring, a thin film A having much of the composition of a ceramic superconducting material is formed as shown in Figure 3B. A key composition for the generation of a superconductivity at a high temperature, for example, liquid nitrogen temperature, is contained in only an interconnection portion 13 of the thin film. A portion 14 between the interconnection portion 13 consist of ceramics containing much of the composition of the interconnection portion 13, but not showing a superconductive property or showing this property only at a very low temperature.

The interconnection portion 13 containing the key composition by which above-mentioned superconduction is generated consists of, for example, an M-L-A-O system ceramic high-temperature superconducting material, wherein M is an alkaline earth metal such as calcium (Ca), strontium (Sr), or a combination of alkaline earth metals, and L is a rare earth element such as yttrium (Y) or lanthanum (La), or a heavy element such as bismuth (Bi) or thallium (Tl) also known as a component of such material able to replace a rare earth element, or a combination of such elements, and A is Cu, Ag or Au or a combination thereof. In such a high-temperature superconducting material, the electrical resistance practically disappears at a transition temperature (Tc) (Figure 4). The insulating portion 14, which does not show the superconductive property, or even if such a property is shown, it appears only at a very low temperature such as 4.2 K or less, has a composition in which one of the characteristic metals of superconducting interconnection portion 13 is omitted to leave a ceramic composition otherwise the same as that of interconnection portion 14 and generally acting as an insulator at temperatures well below the transition temperature Tc of portion 13. For example, L is not present (i.e., M-A-O system material).

Typically, the ceramic superconductive material used in the present invention is an oxide ceramic material represented by the general formula $X_aY_{1-a}ZO_b$ or $(X_{1-a}Y_a)_2ZO_b$ where $0 < a < 1$; $3 \leqq b < 4$; X is at least one element selected from the group of Ba, Ca, Sr, and Mg; Y is at least one element selected from the group of Sc, Y, La, Ce, Pr, Nd, Pm, Sm, Eu, Gd, Tb, Dy, Ho, Er, Tm, Yb, and Lu; and Z is at least one element selected from the group of Cu, Ag, and Au.

X, Y, and Z in the above formula may be more than one element. For example, X may be Ba-Ca-Sr, Ba-Ca-Mg, Ba-Ca, or Ca-Mg; Y may be Sc-Y, Sc-Y-La, Sc-Y-La-Ce, or Pr-Nd and, Z may be Cu-Ag, Cu-Au, Ag-Au, or Cu-Ag-Au.

Thus, the oxide superconductive material may be, for example,
$(Ba_{0.6}Ca_{0.2}Sr_{0.2})_{0.6}(Sc_{0.7}Y_{0.2}La_{0.1})_{0.4}(Cu_{0.8}Ag_{0.2})_3O_{4-w}$ or $(Ba_{0.8}Mg_{0.2})_{0.7}(Sc_{0.6}Nd_{0.4})_{0.3}Cu_3O_{4-\delta}$.

A preferred oxide superconductive material is $\{(M^{II}O)_x(M_{III}O_3)_{1-x}\}_y(CuO)_z(O)_\delta$ wherein $M^{II}$ stands for at least one of Ba, Sr, Ca, and Mg; $M^{III}$ stands for at least one of Y, Sc, La, Ce, Pr, Nd, Sm, Eu, Gd, Tb, Dy, Ho, Er, Tm, Tb, and Lu; $0.5 \leqq x \leqq 0.9$; $1 \leqq y \leqq 2$; $1 \leqq z \leqq 2$; and $\delta$ stands for a deviation of the amount of oxygen from stoichiometry; the oxide superconducting material exhibiting superconductivity above the boiling point of nitrogen (77K).

Another example of a superconducting ceramic material is a bismuth-system (Bi-Sr-Ca-Cu-O system) superconducting ceramic material. The exact chemical formula of the bismuth-system superconducting ceramic material is not known but can be formed from a starting material of a mixture of Bi, Sr, Ca, and Cu compounds in a molar ratio (based on these elements) of 0.25-2:0.1-5:0.1-5:0.5-4. For example, 1:1:1:2; 1:1:1:3, 4:3:3:6; and 4:3:3:4. Further, another superconducting ceramic material can be formed from a starting material of a mixture of Tl, Bi, Sr, Ca, and Cu compounds in a molar ratio (based on these elements) of 0.25-2:0.25-2:0.1-5:0.1-5:0.5-4. These superconducting ceramic materials exhibit superconductivity above the boiling point of nitrogen (77K).

The insulating portion 14 generally has the same thickness as that of the interconnection portion 13.

## Example 1

To produce a target for RF magnetron sputtering, CuO and $BaCO_3$ powders were mixed so that the mol composition ratio Ba:Cu:O was 1:1.5:3.5, and heated or calcined at a temperature of about 950°C for 10 hours in air. The calcined lumps were again powdered, remixed, and pressed to form a wafer-shaped body having a diameter of 100 cm and a thickness of 5 mm, at a pressure of 500 kg/cm$^2$, and reheated or sintered at a temperature of 950°C for 5 hours in an oxygen ($O_2$) gas atmosphere.

Then, to form a thin film as a field region, a planner type RF magnetron sputtering was carried out, using the above-mentioned target, at a deposition rate of about 6 nm/min, in an atmosphere of Ar and 50% $O_2$, at a pressure of 2 to 3 Pa, and at a substrate temperature of 500 to 600°C. The thickness of the obtained Ba-Cu-O thin film was about 500 nm.

Then, yttrium ions ($Y^+$) were implanted into only interconnection portions of the Ba-Cu-O thin film by a focussed ion beam (FIB) process. The $Y^+$ dose was 2 to 3 x $10^{17}$/cm$^2$, at an energy of 100 KeV, and the beam spot had a diameter of about 1 μm.

Then, using a CW $CO_2$ laser, the obtained thin film was annealed at an energy density of 20 W/cm$^2$, a scan speed of 5 cm/sec, with a beam spot having a 100 μm diameter, and in an $O_2$ atmosphere. The substrate was kept at a temperature of 500 to 600°C during the laser-irradiation, and the irradiated spot of the laser was estimated to have a temperature of 1230 to 1250°C, which is near the melting point of the $Y_1Ba_2Cu_3O_{7-x}$. The thus-obtained interconnection portions 13 became superconductive at a critical temperature of 90K, and a Ba-Cu-O thin film portion 14 not implanted by Y maintained an insulative effect at 5K or higher.

## Example 2

An La-(Ba, Sr)-Cu-O superconducting material will now be explained.

A disc or wafer shaped target of La.Ba.Sr.O$_3$ was produced in the same way as in Example 1; and $Cu^+$ ions were then implanted only into interconnecting portions by the FIB process, under the implantation conditions of a dose of 6 to 9 x $10^{17}$ cm$^{-2}$ and at an energy of 100 KeV. Further, $O^+$ ions were implanted therein at a high dose of 2 to 3 x $10^{17}$ cm$^{-2}$ and an energy of 100 KeV, as the thin film was to be encapsulated by $SiO_2$/Poly-Si for a later laser annealing process and the supply of $O_2$ from the atmosphere was lost.

After the ion implantation, a 500 nm thick $SiO_2$ and 400 nm thick non doped poly-Si were deposited on a ceramic thin film by a low pressure CVD process, and the surface of the film was then irradiated with a CW $Ar^+$ laser under the conditions of an energy density of 20 W/cm$^2$, a scan speed of 5 cm/sec, and a beam spot diameter of 100 μm, so that the poly-Si was melted and recrystallized, and then only the Si layer was removed by etching.

The high temperature and short time-annealing in the poly-Si melting time caused the ceramic interconnection portion to become a superconductive ceramic body having a Tc of about 50K (Tc = 50K), and a mainly $K_2NiF_4$ type crystal structure, and the Cu free field portion became a ceramic body having a Tc of lower than 6K (Tc < 6K) and supposedly a perovskite type crystal structure.

Example 3

A Bi-(Ba, Ca)-Cu-O superconductive material will be explained.

A field portion Ba.Ca.Cu.Ox ceramic was formed by an RF sputtering target as in Example 1, and after a $Bi^+$ ion implantation at a dose of 2 to 3 x $10^{17}$ cm$^{-3}$, the surface of the ceramic was irradiated with a $CO_2$ laser in an $O_2$ flow, as in Example 1. The interconnection portion was assumed to be $Bi_2Ba_2Ca_2Cu_3O_{10-x}$, having a Tc of 110K (R = O). The field portion had a Tc of lower than 4.2K (Tc < 4.2K).

As explained above, according to the present invention the interconnection portion can be easily planarized without a pattern-etching of the thin film, or PSG reflow. Further, since the interconnection portion 13 and the portion 14 have substantially the same ceramic composition, the thermal expansion therebetween is substantially the same, and thus stress does not occur.

**Claims**

1. A semiconductor device comprising:
interconnection portions (13) consisting of a ceramic superconducting material and
a portion (14) positioned between said interconnection portions (13) and having much of the composition of said interconnection portions (13) but acting as an electrical insulator with respect to the interconnection portions (13) at temperatures at which the latter are electrically conducting.

2. A semiconductor device according to claim 1, wherein said interconnection portions (13) are superconducting and the superconducting transition temperature (Tc) of the superconducting material of said interconnection portions (13) is higher than that of the material of said portion (14).

3. A semiconductor device according to claim 1, wherein said interconnection portions (13) and said portion (14) are obtained by forming a thin film having an M-L-A-O ceramic composition, wherein M is a component which is an alkaline earth element or a combination of the alkaline earth elements, L is a rare earth element or a combination of rare earth elements, A is copper, silver or gold and O is oxygen, with one of the elements M, L and A being omitted, and the omitted one element or elements is then implanted into only the interconnection portions (13).

4. A semiconductor device according to claim 3, wherein said M-L-A-O ceramic composition is $Y_1Ba_2Cu_3O_{7-x}$ and said ceramic composition wherein any one of the elements M, L and Cu is omitted is Ba-Cu-O.

5. A semiconductor device according to claim 4, wherein said $Y_1Ba_2Cu_3O_{7-x}$ ceramic is such that its superconducting transition point Tc is about 90K (R = O) and said superconducting transition point Tc of said Ba-Cu-O ceramic is about 5K (R = O).

6. A semiconductor device according to claim 3, wherein said M-L-A-O ceramic composition is $La.Ba.Sr.Cu.O_3$ and said ceramic composition wherein any of the elements M, L and Cu is omitted is $La.Ba.Sr.O_3$.

7. A semiconductor device according to claim 2, wherein said $La.Ba.Sr.Cu.O_3$ ceramic has a superconducting transition point Tc of about 50K (R = O) and said superconducting transition point Tc of said $La.Ba.Sr.O_3$ ceramic is about 6K (R = O).

8. A semiconductor device according to claim 1 or 2, wherein said interconnection portions (13) and said portion (14) are obtained by forming a thin film having an M-L-A-O ceramic composition, wherein M is a component which is an alkaline earth element or a combination of alkaline earth elements, L is bismuth or thallium, A is copper, silver or gold, and O is oxygen with one of the elements M, L and Cu being omitted and the omitted one element or elements is then implanted into only the interconnection portions (13).

9. A semiconductor device according to claim 8 wherein said M-L-A-O ceramic composition is $Bi_2Ba_2Ca_2Cu_3O_{10-x}$ and said ceramic composition wherein any one of the elements M, L and Cu is omitted is Ba.Ca.Cu.O$_x$.

10. A semiconductor device according to claim 9, wherein the $Bi_2Ba_2Ca_2Cu_3O_{10-x}$ ceramic has a superconducting transiton point Tc of about 110K (R = O) and said superconducting transition point Tc of the Ba.Ca.Cu.Ox ceramic is about 4.2K (R = O).

11. A semiconductor device comprising:
interconnection portions (13) consisting of a ceramic superconducting material and
a portion (14) positioned between said interconnection portions (13) and having the same main composition as that of said interconnection portions (13) said interconnection portions (13) being electrically insulated by said portion (14).

# Fig. I

# Fig. 4

# Fig. 2

## Fig. 3A

18

19

W

W

GATE

W

N⁺

W

SiO₂

17

N⁺

P

N⁺

SiO₂

SiO₂

16

11

15

12

10

## Fig. 3B

14 (low Tc)

13 (high Tc)

A

W

N⁺

W

SiO₂

N⁺

P

N⁺

SiO₂

16

11

15

12

10